# EUROPEAN PATENT SPECIFICATION

(11) **EP 0 909 022 B1**
(45) Date of publication and mention of the grant of the patent: **20.10.2004**
(21) Application number: 98307895.7
(22) Date of filing: 29.09.1998
(51) Int. Cl.: H03G 1/00

(54) **Gain control circuit**
Verstärkungssteuerungsschaltung
Circuit de commande de gain

(30) Priority: 13.10.1997 JP 27846297
(43) Date of publication of application: 14.04.1999
(73) Proprietor: ALPS ELECTRIC CO., LTD., Ota-ku Tokyo 145 (JP)
(72) Inventor: Tanaka, Ryoichi, Soma-shi, Fukushima-ken (JP)
(74) Representative: Kensett, John Hinton

(56) References cited:
- US-A- 4 806 876
- PATENT ABSTRACTS OF JAPAN vol. 004, no. 010 (E-167), 25 January 1980 (1980-01-25) -& JP 54 150056 A (MATSUSHITA ELECTRIC IND CO LTD), 24 November 1979 (1979-11-24)
- PATENT ABSTRACTS OF JAPAN vol. 012, no. 461 (E-689), 5 December 1988 (1988-12-05) & JP 63 185212 A (HITACHI LTD;OTHERS: 01), 30 July 1988 (1988-07-30)

## Description

The present invention relates to gain control circuits used in input circuits of television tuners, etc.

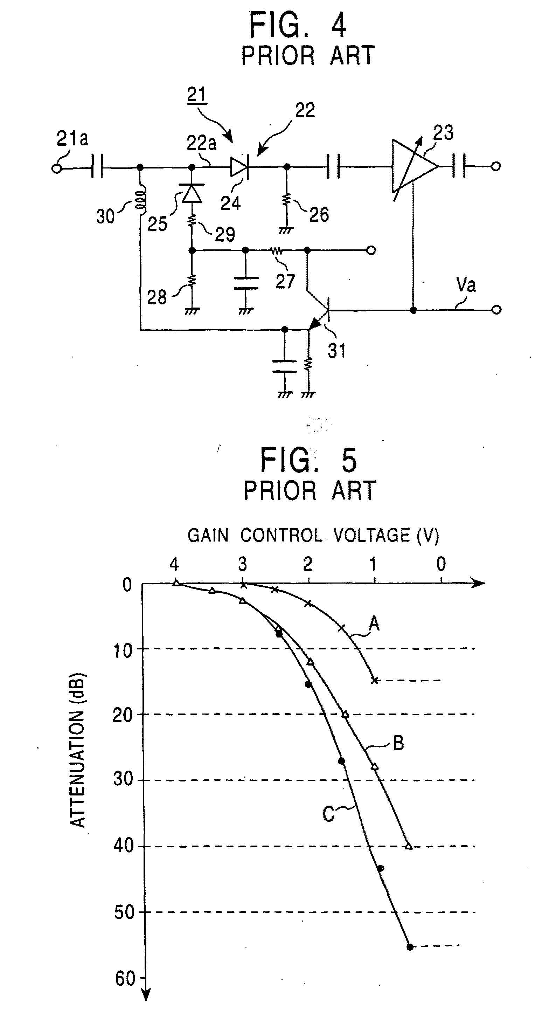

A conventional gain control circuit will be described with reference to Figs. 4 and 5. Fig. 4 shows the structure of a conventional gain control circuit, and Fig. 5 shows attenuation characteristics of the conventional gain control circuit.

In Fig. 4, a gain control circuit 21 includes: a variable attenuation circuit 22 and a variable gain-amplification circuit 23. The variable attenuation circuit 22 is provided between a signal-input end 21a and the variable gain-amplification circuit 23. A common gain-control voltage Va is supplied to the variable attenuation circuit 21 and the variable gain-amplification circuit 23.

The variable attenuation circuit 22 includes: a first PIN diode 24 connected in series in a signal transmission path 22a connecting the input end 21a and the variable gain-amplification circuit 23; and a second PIN diode 25. The cathode of the second PIN diode 25 is connected to the anode of the first PIN diode 24. The cathode of the first PIN diode 24 is connected to the ground via a resistor 26 for direct-current voltage. A voltage obtained by dividing a power-supply voltage B with voltage-dividing resistors 27 and 28 is applied as a fixed bias voltage to the anode of the second PIN diode 25 via a resistor 29.

One end of a high-frequency-blocking choke inductor 30 is connected to the anode of the first PIN diode 24 and the cathode of the second PIN diode 25, and another end of the choke inductor 30 is connected to the emitter of an emitter-follower transistor 31. A common gain-control voltage Va is supplied to the base of the emitter-follower transistor 31.

In the variable gain-amplification circuit 23, a dual-gate field-effect transistor (FET) (not shown) is used as an amplifier element. A signal having passed through the variable attenuation circuit 22 is input to a first gate of the dual-gate FET, and the common gain-control voltage Va is supplied to a second gate of the dual-gate FET.

The gain-control voltage Va decreases at 4 volts. As shown in Fig. 5, when it is 4 volts, an attenuation by the variable attenuation circuit 22 and a gain attenuation by the variable gain-amplification circuit 23 are approximately 0 dB, and the attenuation increases as the gain-control voltage Va decreases.

In other words, when the gain-control voltage Va is, for example, 4 volts, a sufficient current flows in the first PIN diode 24 and the resistor 26 via the emitter-follower transistor 31 and the choke inductor 31, while no current flows in the second PIN diode 25 because the resistances of the voltage-dividing resistors 27 and 28 are determined so that a reverse bias is applied to the second PIN diode 25. Accordingly, the attenuation by the variable attenuation circuit 22 is approximately 0 dB. As the gain-control voltage Va decreases at 4 volts, the voltages of the anode of first PIN diode 24 and the cathode of the second PIN diode 25 decrease, and the current of the first PIN diode 24 decreases. At the same time, a current begins to flow in the second PIN diode 25. Therefore, the signal input to the input end 21a is attenuated before being input to the variable gain-amplification circuit 23.

In this case, the current flowing in the first PIN diode 24 is the sum of a current from the emitter-follower transistor 31 based on the gain-control voltage Va and the current flowing in the second PIN diode 25.

In addition, also in the variable gain-amplification circuit 23, as the gain-control voltage Va decreases, the drain current decreases and the mutual conductance decreases, so that the gain decreases.

In Fig. 5, attenuation characteristics of the variable attenuation circuit 22 and attenuation characteristics of the variable gain-amplification circuit 23 are shown. The curve A represents attenuation characteristics of the variable attenuation circuit 22, and the curve B represents attenuation characteristics of the variable gain-amplification circuit 23. The curve C represents a total (the sum) of the attenuation characteristics. From Fig. 5, it is seen that a change in the attenuation with respect to the same gain-control voltage, namely, an inclination of attenuation is more gradual in the variable attenuation circuit 22. The reason the attenuation characteristic of the variable attenuation circuit 22 is more gradual is that a current flows in the first PIN diode 24 via the second PIN diode 25, even if the gain-control voltage Va decreases.

Therefore, concerning a particular range of the gain-control voltage Va, the proportion of the attenuation by the variable gain-amplification circuit 23 to the total attenuation is greater, and the attenuation by the variable attenuation circuit 22 is conversely smaller. Accordingly, the level of the signal input to the variable gain-amplification circuit 23 is large to increase distortion generated in the variable gain-amplification circuit 23.

Concerning the FET itself as an amplifier element used in the variable gain-amplification circuit 23, it is known that an attenuation of approximately 100 dB or more increases distortion. If an attenuation by the variable attenuation circuit 22 is small when such an amplifier element is used, the total distortion further deteriorates.

As described above, according to the conventional gain control circuit 21, an inclination of attenuation characteristics by the variable attenuation circuit 22 at a stage before the variable gain-amplification circuit 23 is gentler than that of attenuation characteristics by the variable gain-amplification circuit 23. This causes large distortion.

Further details in relation to conventional gain control circuits can be found in JP-A-54150056.

Accordingly, it is an object of the present invention to provide a gain control circuit for reducing distortion in the process of gain control.

According to the present invention there is provided a gain control circuit comprising: a variable attenuation circuit and a variable gain-amplification circuit comprising a FET as an amplifier element, the attenuation of the variable attenuation circuit and the gain of the variable gain-amplification circuit being controlled using a common gain-control voltage, and the variable attenuation circuit being provided between a signal input end and the variable gain-amplification circuit; and an emitter-follower transistor between the emitter of which and the ground a capacitor is provided; wherein the variable attenuation circuit includes a first diode, connected in series in a signal transmission path between the input end and the variable gain-amplification circuit, and a second diode, provided between the signal transmission path and the ground, to the anode of which a fixed bias voltage is applied; and wherein the gain-control voltage is supplied to the variable gain-amplification circuit and to the base of the emitter-follower transistor, and from the emitter of the emitter-follower transistor to the anode of the first diode via an inductor; characterised in that the cathode of the second diode is connected to the cathode of the first diode at a point on the signal transmission path that lies between the first diode and the variable gain amplification circuit, the cathodes of respective first and second diodes are connected to the ground for direct current via a resistor, and in that the current flowing in the first diode decreases due to a decrease in the gain-control voltage.

Preferably, the first diode is a PIN diode and the second diode is a PIN diode. A direction in which a current flowing in the first diode increases or decreases is opposite to a direction in which a current flowing in the second diode increases or decreases.

According to the present invention, a variable gain-amplification circuit is connected to the output of a variable attenuation circuit so that attenuation by the variable attenuation circuit starts after gain attenuation by the variable gain-amplification circuit starts, whereby an inclination of the attenuation by the variable attenuation circuit is steeper than that of the gain attenuation by the variable gain-amplification circuit. Thus, the amount of attenuation by the variable attenuation circuit for the same gain-control voltage is greater, whereby the level of a signal input to the variable gain-amplification circuit decreases, which suppresses distortion generated in the variable gain-amplification circuit.

According to the present invention, a direction in which a current flowing in a first PIN diode increases or decreases is reverse to a direction in which a current flowing in a second PIN diode increases or decreases, whereby, in the process of gain control, the current flowing in the second PIN diode does not flow in the first PIN diode. Thus, only a decrease in a gain-control voltage reduces the current flowing in the first PIN diode. Therefore, the resistance of the first PIN diode rapidly increases, and also the amount of attenuation rapidly increases.

According to the present invention, by setting a fixed bias voltage, a gain-control voltage, obtained when a current begins to flow in a second PIN diode, can be set. Therefore, at the gain-control voltage obtained when distortion in a variable gain-amplification circuit increases, the amount of attenuation can be increased.

According to the present invention, it is possible that the start of attenuation by a variable attenuation circuit is easily delayed than the start of gain attenuation by a variable gain-amplification circuit.

Embodiments of the invention, will now be described, by way of example only, with reference to the accompanying drawings, in which:
Fig. 1 is a circuit diagram showing a gain control circuit of the present invention.
Fig. 2 is a graph showing gain attenuation by a gain control circuit of the present invention.
Fig. 3 is a graph showing characteristics of distortion in a gain control circuit of the present invention.
Fig. 4 is a circuit diagram showing a conventional gain control circuit.
Fig. 5 is a graph showing gain attenuation by a conventional gain control circuit.

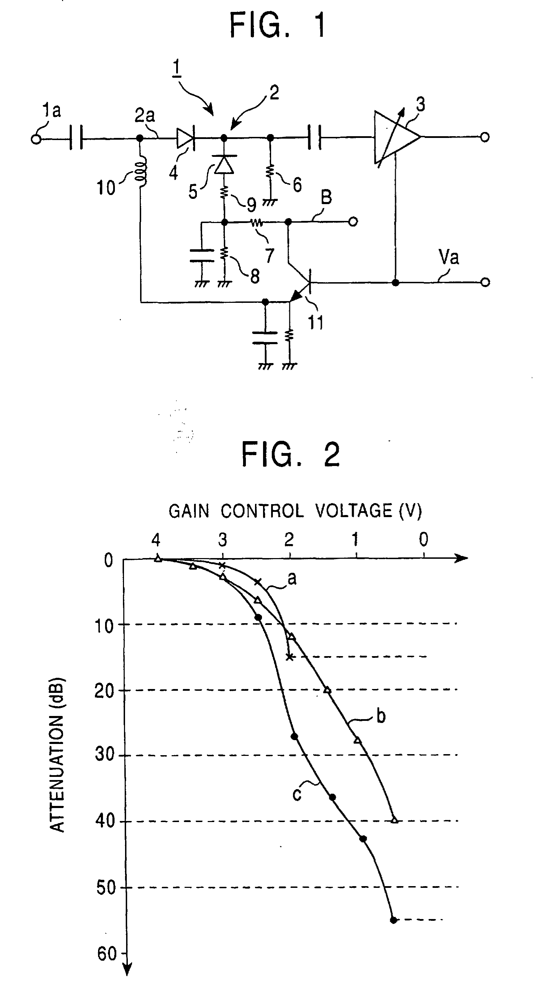

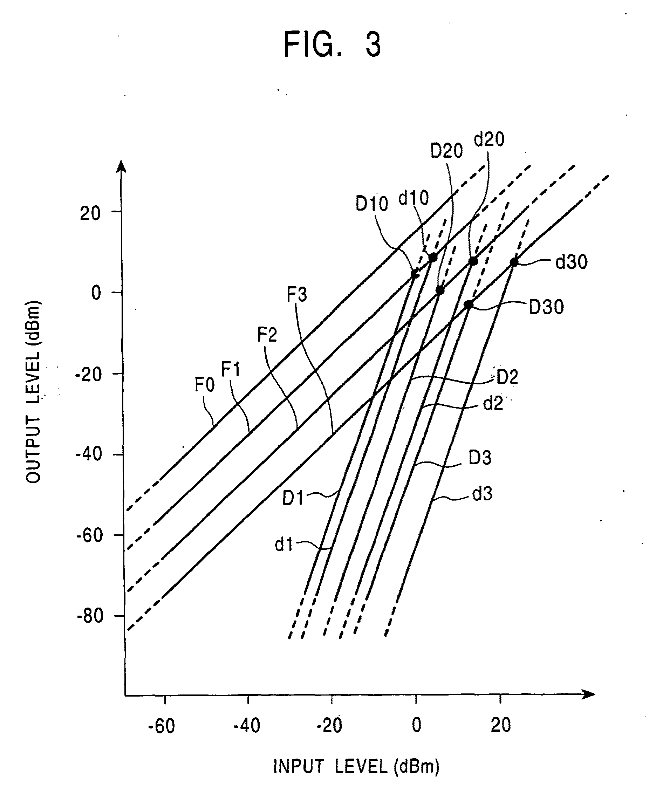

A gain control circuit of the present invention will be described with reference to Figs. 1 to 3. Fig. 1 shows the structure of a gain control circuit of the present invention. Figs. 2 and 3 show attenuation characteristics and distortion characteristic of the gain control circuit of the present invention, respectively.

In Fig. 1, a gain control circuit 1 includes a variable attenuation circuit 2 and a variable gain-amplification circuit 3. The variable amplification circuit 2 is provided between a signal-input end 1a and the variable gain-amplification circuit 3. A common gain-control voltage Va is supplied to the variable amplification circuit 1 and the variable gain-amplification circuit 3.

The variable amplification circuit 2 includes: a first PIN diode 4 connected in series in a signal transmission path 2a connecting the input end 1a and the variable gain-amplification circuit 3; and a second PIN diode 5 connected in series between the signal transmission path 2a and the ground. The cathode of the second PIN diode 5 is connected to the cathode of the first PIN diode 4. The cathode of the first PIN diode 4 and the cathode of the second PIN diode 5 are connected to the ground via a resistor 6 for direct-current voltage. A voltage obtained by dividing a power-supply voltage B using voltage-dividing resistors 7 and 8 is supplied as a fixed bias voltage to the anode of the second PIN diode 5 via a resistor 9.

An end of a high-frequency-blocking choke inductor 10 is connected to the anode of the first PIN diode 4, and another end thereof is connected to the emitter of the emitter-follower transistor 11, whereby the common gain-control voltage Va is supplied to the base of the emitter-follower transistor 11.

In the variable gain-amplification circuit 3, a dual-gate FET (not shown) is used as an amplifier element. A signal having passed through the variable amplification circuit 2 is input to a first gate of the FET, and the common gain-control voltage Va is supplied to a second gate of the FET. The common gain-control voltage Va decreases at 4 volts. As shown in Fig. 2, when it is 4 volts, the amount of attenuation by the variable attenuation circuit 2 and the amount of gain attenuation by the variable gain-amplification circuit 3 are approximately 0 dB, and the amount of attenuation increases as the gain-control voltage Va decreases.

In other words, when the gain-control voltage Va is 4 volts, a sufficient current flows in the first PIN diode 4 and a resistor 6 via the emitter-follower transistor 11 and the choke inductor 10, while no current flows in the second PIN diode 5 because the resistances of the voltage-dividing resistors 7 and 8 are determined so that a reverse bias voltage is applied to the second PIN diode 5. Accordingly, the amount of attenuation is approximately 0 dB. As the gain-control voltage Va decreases at 4 volts, the cathode voltage of the first PIN diode 4 decrease, and a current begins to flow in the second PIN diode 5. Therefore, the signal input to the input end 1a is attenuated before being input to the variable gain-amplification circuit 3.

In this case, the current flowing in the first PIN diode 24 and the current flowing in the second PIN diode 25 are added, and the sum flows in the resistor 6.

Also, in the variable gain-amplification circuit 3, as the gain-control voltage Va decreases, the drain current decreases and mutual conductance decreases, so that the gain decreases.

In the variable attenuation circuit 2 in the gain control circuit 1 of the present invention, in the process of gain control, the current flowing in the second PIN diode 5 does not flow in the first PIN diode 4. Thus, the current flowing in the first PIN diode decreases due to only a decrease in the gain-control voltage Va. Accordingly, the resistance of the first PIN diode 4 rapidly increases, and the amount of attenuation rapidly increases as represented by the curve "a" shown in Fig. 2. The curve "b" shown in Fig. 2 represents gain-attenuation characteristics of the variable gain-amplification circuit 3. The comparison between the curves "a" and "b" indicates that, at an attenuation of approximately 5 dB or more, the inclination of attenuation characteristics of the variable attenuation circuit 2 is steeper than that of attenuation characteristics of the variable gain-amplification circuit 3. The curve C represents the sum of the attenuation by the variable attenuation circuit 2 and the gain attenuation by the variable gain-amplification circuit 3.

As a result, around an attenuation of approximately 5 dB, the amount of attenuation by the variable attenuation circuit 2 is large. Thus, the signal level input to the variable gain-amplification circuit 3 decreases to suppress distortion generated in the variable gain-amplification circuit 3.

Fig. 3 shows the comparison between third distortions (IM3) of the conventional gain-control circuit 21 and the gain control circuit 1 of the present invention. In Fig. 3, the curves F0, F1, F2, and F3, represent the input and output characteristics of fundamental waves obtained when the amount of the overall attenuation is 0 dB, 10 dB, 20 dB, and 30 dB, respectively. The curves D1, D2, and D3, represent the characteristics of third distortion in the conventional gain control circuit 21, which are obtained when the amount of the overall attenuation is 10 dB, 20 dB, and 30 dB, respectively. The curves d1, d2, and d3, represent third distortion characteristics in the gain control circuit 1 of the present invention, which are obtained when the amount of the overall attenuation is 10 dB, 20 dB, and 30 dB, respectively. As will be understood from the comparison, in accordance with an increase in the amount of attenuation, in the gain control circuit of the present invention, an interceptor point is improved from D10 to d10, and D20 improves to d20 at an attenuation of 20 dB and D30 improves to d30 at an attenuation of 30 dB.

## Claims

1. A gain control circuit (1) comprising:
a variable attenuation circuit (2) and a variable gain-amplification circuit (3) comprising a FET as an amplifier element, the attenuation of the variable attenuation circuit and the gain of the variable gain-amplification circuit being controlled using a common gain-control voltage (Vₐ), and the variable attenuation circuit being provided between a signal input end (1a) and the variable gain-amplification circuit;
and an emitter-follower transistor (11) between the emitter of which and the ground a capacitor is provided;
wherein the variable attenuation circuit includes a first diode (4), connected in series in a signal transmission path (2a) between the input end (1a) and the variable gain-amplification circuit, and a second diode (5), provided between the signal transmission path (2a) and the ground, to the anode of which a fixed bias voltage is applied;
and wherein the gain-control voltage (Vₐ) is supplied to the variable gain-amplification circuit and to the base of the emitter-follower transistor, and from the emitter of the emitter-follower transistor to the anode of the first diode (4) via an inductor (10);
**characterised in that** the cathode of the second diode is connected to the cathode of the first diode at a point on the signal transmission path (2a) that lies between the first diode and the variable gain amplification circuit, the cathodes of respective first and second diodes are connected to the ground for direct current via a resistor (6), and **in that** the current flowing in the first diode decreases due to a decrease in the gain-control voltage.

2. A gain control circuit according to Claim 1, wherein the first diode is a PIN diode and the second diode is a PIN diode and a direction in which a current flowing in said first diode increases or decreases is opposite to a direction in which a current flowing in said second diode increases or decreases.

## Patentansprüche

1. Verstärkungssteuerungsschaltung (1), aufweisend:
eine variable Dämpfungsschaltung (2) und eine variable Verstärkungsschaltung (3), die einen FET als ein Verstärkerelement aufweist, wobei die Dämpfung der variablen Dämpfungsschaltung und die Verstärkung der variablen Verstärkungsschaltung unter Verwendung einer gemeinsamen Verstärkungssteuerungsspannung (Vₐ) gesteuert werden und die variable Dämpfungsschaltung zwischen einem Signaleingangsende (1a) und der variablen Verstärkungsschaltung vorgesehen ist;
und einen Emitterfolgertransistor (11), wobei zwischen dessen Emitter und der Masse ein Kondensator vorgesehen ist;
wobei die variable Dämpfungsschaltung eine erste Diode (4), die in Serie in einen Signalübertragungspfad (2a) zwischen dem Eingangsende (1a) und der variablen Verstärkungsschaltung geschaltet ist, und eine zweite Diode (5) aufweist, die zwischen dem Signalübertragungspfad (2a) und der Masse vorgesehen ist, wobei an deren Anode eine feste Vorspannung angelegt wird;
und wobei die Verstärkungssteuerungsspannung (Vₐ) an die variable Verstärkungsschaltung und an die Basis des Emitterfolgertransistors und von dem Emitter des Emitterfolgertransistors über eine Induktivität (10) an die Anode der ersten Diode (4) geliefert wird;
**dadurch gekennzeichnet, dass**
die Kathode der zweiten Diode an die Kathode der ersten Diode angeschlossen ist, und zwar an einem Punkt in dem Signalübertragungspfad (2a), der zwischen der ersten Diode und der variablen Verstärkungsschaltung liegt, wobei die Kathoden beider Dioden gleichstrommäßig über einen Widerstand (6) an die Masse angeschlossen sind, und dass der in der ersten Diode fließende Strom aufgrund einer Abnahme der Verstärkungssteuerungsspannung abnimmt.

2. Verstärkungssteuerungsschaltung nach Anspruch 1, wobei die erste Diode eine PIN-Diode und die zweite Diode eine PIN-Diode ist und eine Richtung, in der ein in der ersten Diode fließender Strom zunimmt oder abnimmt, einer Richtung entgegengesetzt ist, in der ein in der zweiten Diode fließender Strom zunimmt oder abnimmt.

## Revendications

1. Circuit de commande de gain (1) comprenant :
un circuit d'atténuation variable (2) et un circuit d'amplification à gain variable (3) comprenant un transistor à effet de champ comme élément amplificateur, l'atténuation du circuit d'atténuation variable et le gain du circuit d'amplification à gain variable étant contrôlés à l'aide d'une tension de commande de gain commune (Vₐ), et le circuit d'atténuation variable étant prévu entre une extrémité d'entrée (1a) de signal et le circuit d'amplification à gain variable ;
et un transistor à montage émetteur-suiveur (11) entre l'émetteur duquel et la terre est agencé un condensateur;
dans lequel le circuit d'atténuation variable inclut une première diode (4), raccordée en série dans un chemin de transmission du signal (2a) entre l'extrémité d'entrée (1a) et le circuit d'amplification à gain variable, et une seconde diode (5), prévue entre le chemin de transmission de signal (2a) et la terre, à l'anode de laquelle est appliquée une tension de polarisation fixe ;
et dans lequel la tension de commande de gain (Vₐ) est fournie au circuit d'amplification à commande de gain variable et à la base du transistor à montage émetteur-suiveur, et depuis l'émetteur du transistor à montage émetteur-suiveur vers l'anode de la première diode (4) via un inducteur (10) ;
**caractérisé en ce que** la cathode de la seconde diode est raccordée à la cathode de la première diode au niveau d'un point du chemin de transmission de signal (2a) qui est situé entre la première diode et le circuit d'amplification à gain variable, les cathodes des première et seconde diodes respectives étant raccordées à la terre pour un courant continu via une résistance (6), et **en ce que** le courant circulant dans la première diode diminue en raison d'une diminution de la tension de commande de gain.

2. Circuit de commande de gain selon la revendication 1, dans lequel la première diode est une diode PIN et la seconde diode est une diode PIN, et la direction dans laquelle le courant circulant dans ladite première diode augmente ou diminue est opposée à la direction dans laquelle le courant circulant dans ladite seconde diode augmente ou diminue.
